# EUROPEAN PATENT SPECIFICATION

(11) **EP 0 494 634 B1**
(45) Date of publication and mention of the grant of the patent: **02.04.1997**
(21) Application number: 92100139.2
(22) Date of filing: 07.01.1992
(51) Int. Cl.: H01L 23/31, H01L 21/56, B05D 1/04

(54) **Methods of applying substance to integrated circuit die and lead frames to improve adhesion to mold compound, and apparatus therefor**
Verfahren zum Aufbringen einer Substanz auf einen IC-Chip und auf Leiterrahmen zur Verbesserung der Adhäsion mit Formgussmischung, und Gerät
Méthodes pour appliquer une substance à un chip de circuit intégré et à des cadres conducteurs pour améliorer leur adhésion au composé de scellement, et appareillage

(30) Priority: 08.01.1991 US 638776
(43) Date of publication of application: 15.07.1992
(60) Divisional application: 93110939.1
(73) Proprietor: TEXAS INSTRUMENTS INCORPORATED, Dallas Texas 75265 (US)
(72) Inventor: McKenna, Robert G., Houston, Texas 77043 (US)
(74) Representative: Leiser, Gottfried, Dipl.-Ing.

(56) References cited:
- GB-A- 2 211 113
- IEEE TRANSACTIONS ON COMPONENTS, HYBRIDS, AND MANUFACTURING TECHNOLOGY vol. 13, no. 4, December 1990, pages 940-945, New York, US; D. SUHL: "Thermally Induced IC Package Cracking"
- PATENT ABSTRACTS OF JAPAN vol. 8, no. 74 (E-236)(1511), 6 April 1984; & JP - A - 58223331
- PATENT ABSTRACTS OF JAPAN vol. 12, no. 71 (P-673), 5 March 1988; & JP - A - 62211643
- English translation of JP-A-58-223331
- "The LP-III Vacuum Vapor Primer", Yield Engineering Systems Inc. 1985

## Description

This invention generally relates to a method of applying a substance to integrated circuit die and lead frames to improve adhesion for various purposes. The invention is more specifically directed to an atomized charged particle application method as defined in claim 1 and an apparatus for making integrated circuits as defined in claim 6.

Without limiting the scope of the invention, its background is described in connection with manufacture of integrated circuits, as an example.

Manufacture of integrated circuits involves a first process of making dies, usually made of a semiconductor material having microscopically small circuits fabricated on a wafer which is then divided into dies or chips. Then in a subsequent assembly process, a die is electrically connected to a lead frame. The lead frame and die are affixed to or surrounded by a package such as by molding. In this way, an integrated circuit product is made with external conductor elements such as pins or surface mount elements that are internally connected to the die.

Heretofore, in the assembly process, removal of a molded integrated circuit part from a mold was hindered by adhesion between the molded package and the mold itself. Anything put into the molding compound to make it easy to remove the molded part from the mold also disadvantageously reduced the adhesion between the molding compound and the die surface and lead frame.

A package cracking phenomenon is sometimes experienced by plastic leaded chip carriers (PLCCs), plastic quad flat packs (PQFPs) and small outline integrated circuits (SOICs) when processed through a reflow soldering process to connect the integrated circuit product to a printed circuit board. Large molded tantalum capacitors and plastic through-hole mounted components, such as plastic dual-in-line packages (PDIP) can also crack if exposed to the reflow soldering process. This cracking can occur when a plastic package is allowed to accumulate moisture prior to soldering. The moisture flashes to steam during the solder reflow operation, causing sufficient stress to crack the package and thus compromise package integrity. Package cracking is sometimes called the "popcorn phenomenon." The resulting stress caused by moisture flashing into steam and by mismatch of thermal expansion coefficients between mold compound, lead frame and silicon die can be enough to cause delamination between the mold compound and the lead frame and/or die. Even the ball bonds can be sheared from bond pads, and the semiconductor of the die itself can be cracked.

Accordingly, improvements which overcome any or all of the problems are presently desirable. In an approach of coassigned incorporated application 455,210, polyimide is on the backside of an integrated circuit to prevent plastic encapsulated IC package cracking during surface mount.

Another approach is dislcosed in D. Suhl: "Thermally Induced IC Package Cracking", IEEE TRANSACTIONS ON COMPONENTS, HYBRIDS, AND MANUFACTURING TECHNOLOGY, Vol. 13, No. 4. Dec. 1990, pp 940-945 where a metal lead frame of an electronic component can be coated with a thin film of adhesion promoter. However, as either immersion, spin coating or vapor priming is suggested as application method, the electronic component must be kept in a sealed container during fabrication. In addition, only complete silicon wafers, i.e. a plurality of dies or chips can be processed.

From PATENT ABSTRACTS OF JAPAN, Vol. 8, No. 74 (E-236) (1511), 6 April 1984, & JP-A-58 23331 a coating method is known where wax in an organic solvent solution is applied to a semiconductor wafer by atomizing the wax solution after establishing a very large potential difference between the wax vessel and the wafer, however, without impact on the adhesion of the wafer. While a thin uniform layer can be formed on the wafer, here too, only a plurality of dies and chips can be processed on a single side at a given time.

Hence, it is an object of the invention to overcome the above-mentioned problems and to provide a multiple-side adhesion-enhancing coating process for at least one die or chip.

In the invention according to claim 1, a process of making an electronic component has steps of providing an adhesion promoting substance to an applicator device operable to atomize the adhesion promoting substance, establishing a potential difference between the applicator device and the electronic component, and atomizing the adhesion promoting substance near the electronic component so that the potential difference attracts the adhesion promoting substance to the electronic component thereby depositing the adhesion promoting substance on a front side and a rear side of the electronic component.

An advantage of this form of the invention is that processing of electronic components is uncomplicated and inexpensive to provide adhesion promoting substance.

Generally, and in another form of the invention an integrated circuit has pins, a layer of adhesion promoting substance deposited on the pins, and a package material molded onto the pins and the adhesion promoting substance.

An advantage of the latter form of the invention is that adhesion of the mold compound to the integrated circuit can be increased even when the mold compound is provided with an additive to make it easier to remove the molded part from the mold.

An apparatus according to the invention is defined in claim 6.

In the drawings:
FIG. 1 is a partially block, partially pictorial diagram of apparatus for applying atomized charged particles of HMDS to a front and a rear side of a die and lead frame surface prior to plastic molding, thus providing an improved process of integrated circuit manufacture;
FIG. 2 is a process flow diagram of the improved process of integrated circuit manufacture performed by the apparatus of FIG. 1;
FIG. 3 is a pictorial diagram of an integrated circuit product improved according to the process of manufacture of FIG. 2;
FIG. 4 is a microscopic cross-section of part of the integrated circuit product of FIG. 3;
FIG. 5 is a graph of displacement versus tension illustrating improved adhesion and cracking resistance of the improved integrated circuit product of FIG. 3.

Corresponding numerals and symbols in the different figures refer to corresponding parts unless otherwise indicated.

In assembling and packaging, an integrated circuit in the form of a semiconductor die is attached to a support pad of a lead frame. Contact or bond pads on the semiconductor die are then individually connected by wire bonding to corresponding contact pads on the ends of the leads. According to a preferred process embodiment, before molding, an atomized, electrically charged adhesion promoter is applied to the front side and the rear side of the die and the lead frame.

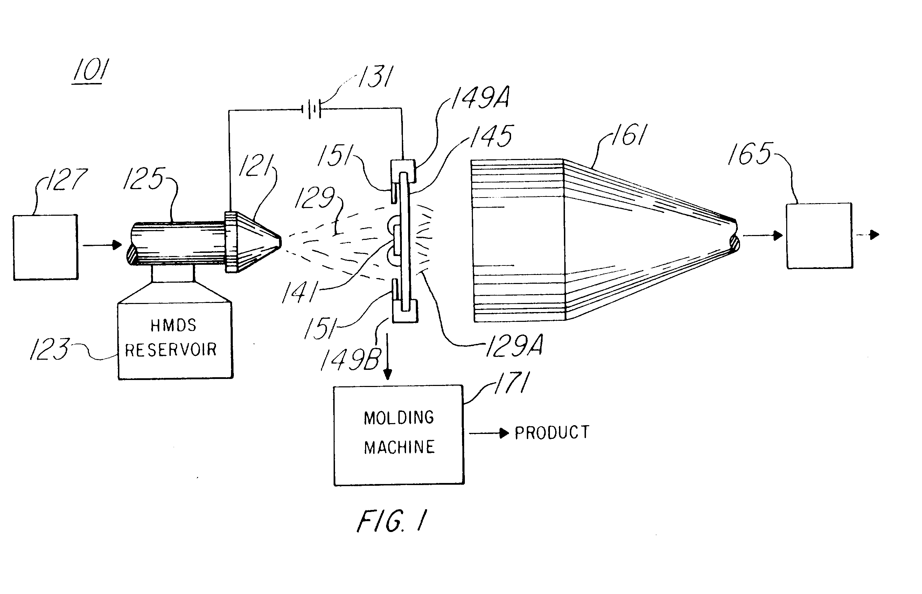

In FIG. 1, apparatus 101 has an atomizer 121 which is fed from a reservoir 123 by a tube 125. Reservoir 123 holds an adhesion promoter such as hexamethyldisilazane (HMDS) in liquid form. A compressed air source 127 draws the adhesion promoter to the atomizer 121 to generate a cloud of HMDS particles 129.

A power supply 131 is connected with a negative terminal to atomizer 121. Atomizer 121 is made of metal or other conductive material to negatively charge the HMDS particles 129 as they leave the nozzle of atomizer 121. The charged particles 129 are attracted to the front and rear surface of an integrated circuit die 141 and to a lead front side and the rear side of a frame 145 of the integrated circuit.

Die 141 and lead frame 145 are held in conductive rails 149A and 149B. The conductive rails 149A and 149B are electrically connected to a positive terminal of power supply 131. In this way the die 141 and lead frame 145 are positively charged and thus counter-charged by power supply 131 with respect to the HMDS particles 129 and the atomizer 121 from which they emanated.

The voltage of power supply 131 is set high enough to achieve the attraction of the atomized particles to the die and lead frame 141, 145. The voltage is in the range 200-500 volts; and 350 volts is suitable, for instance. The polarity of the power supply connections can also be reversed from the polarity shown in FIG. 1. The spacing or separation between the nozzle orifice or orifices and the lead frame assembly is on the order of 2.5 cm (1 inch) and in a range of 1-20 cm for instance.

The separation is established at a value that concentrates the atomized material on the die and lead frame 141,145 and minimizes wastage. The nozzle orifice diameter and ejection velocity of material therefrom are selected and adjusted to effectively atomize the adhesion promoter. The orifice diameter is suitably less then 1 mm and even 0.1 mm for example.

A mask 151 directs the charged particles to the front and rear area of the die 141 and the leadframe 145 which is desired to have high adhesion to a mold compound to be subsequently applied by a molding machine 171. Overspray is drawn into a vacuum hood 161 to be exhausted to environmental controlled equipment such as an air scrubber 165. The lead frame 145 with die 141 are then placed in molding machine 171.

The molding machine 171 is provided with a reservoir containing a quantity of insulating, molding compound. The molding compound is injected into a mold to encapsulate the integrated circuit. Such injection molding is accomplished as described, for example in U.S. patents 4,043,027; 4,504,435, 4,697,784 and 4,915,607.

US-A-4,915,607 also describes a lead frame assembly for an integrated circuit molding system.

Apparatus 101 advantageously is used for making integrated circuits having a semiconductive material and conductive elements, the apparatus for use with a molding device and a molding compound. Atomizer 121 is one example of an applicator device provided with and operable to atomize an adhesion promoting substance. Power supply 131 can be a voltage source connected to establish a potential difference between the conductive elements of the integrated circuit and the applicator device. Apparatus 101 can be used for making encapsulated transistors, capacitors, resistors, and other electronic devices.

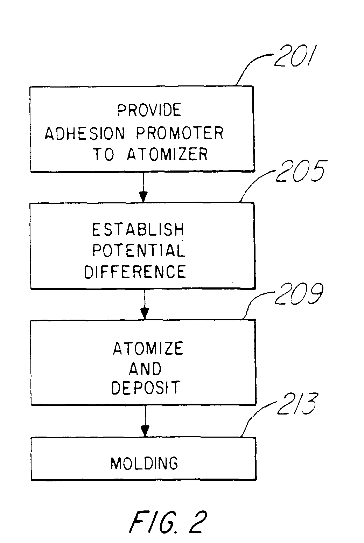

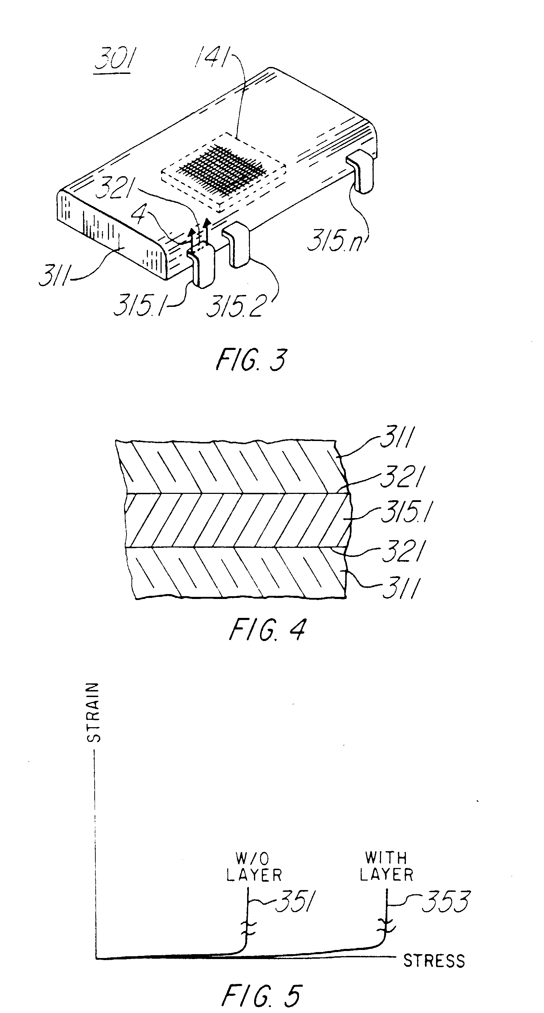

FIG. 2 shows a process of making integrated circuits of FIG. 3 having a semiconductor material 141 and conductive elements 315.1,.2,.n and to be provided with molding compound to make a molded package 311.

In FIG. 2 a step 201 provides an adhesion promoting substance such as HMDS to the applicator device 121 of FIG. 1 operable to atomize the adhesion promoting substance. The substance is of a type that promotes adhesion between the conductive elements 315 and the molding compound 311. A following step 205 establishes a potential difference between the applicator device 121 and the conductive elements of the integrated circuit such as those of the lead frame in manufacture.

Step 209 atomizes the adhesion promoting substance near the integrated circuit so that the potential difference attracts the adhesion promoting substance to the conductive elements more than to the semiconductor material and any insulating material. However, the biasing effect of the potential difference does advantageously attract adhesion promoter to the semiconductor area in the periphery of the die surrounding the ball bonds which is an area of mechanical stress concentration. Preferably the mask 151 is made of insulator so that buildup of atomized adhesion promoter is minimized. Aternatively, the mask is made of metal charged to the same potential as the adhesion promoter so that the adhesion promoter is preferentially attracted to the semiconductor die and ball bonds instead of the mask 151. Then in a step 213 the mold compound is molded onto the conductive elements by molding machine 171 of FIG 1.

Further discussing the lead frames and the molding step 213, the lead frames can be formed in a continuous strip prior to atomizer HMDS deposition. Each lead frame of a strip has an integrated circuit die attached to the support pad as described above. The support pads are themselves supported by a pair of support arms between two parallel siderails. Each siderail is located in the plane of the lead frame and on opposite sides of the die pad. In manufacture of a dual inline package as shown in FIG. 3, one lead frame serially follows the next. In manufacture of a matrix package, a plurality of lead frames are disposed between opposing siderails with transverse carrier arms disposed between the two side rails for receiving the support arms of the die pad. In the molding operation, mold cavities are formed around the lead frames. The mold cavities tightly close and seal upon the leads themselves as well as a dam bar. The dam bar has a transverse portion that extends between a pair of adjoining leads. The dam bar restricts the flow of encapsulated material from the enclosed lead frame. After encapsulation, the dam bar and a portion of the mold flashing projecting between adjoining leads is removed by a punch. The punch is a metal punch that readily severs the metallic dam bar and also removes a portion of the projected mold flashing from between the lead frames. Trim and forming operations sever the lead frame from its siderails in further steps of integrated circuit manufacture. An integrated circuit with reduced mold flash is described in US-A-5 070 039 filed April 13, 1989.

FIG. 3 illustrates an integrated circuit product 301 thus resulting from the steps of FIG. 2. A vanishingly thin layer 321 of atomized deposited adhesion promoter promotes adhesion between each of the pins 315.1-.n to the mold compound 311 of the plastic package, as well as adhesion of die 141 to the package. The integrated circuit 301 thus has pins 315, a microscopic layer 321 of atomized adhesion promoting substance deposited on the pins, and a package material 311 molded onto the pins 315 and the adhesion promoting substance 321.

In another aspect, the FIG. 2 process of making integrated circuits having a die and lead frame in manufacture, provides hexamethyldisilazane to an atomizer in step 201, connects a voltage source in step 205 to establish a potential difference between the atomizer and the lead frame of the integrated circuit, and then in step 209 atomizes the hexamethyldisilazane in the vicinity of the integrated circuit thereby depositing the hexamethyldisilazane on the lead frame under the influence of the potential difference. Step 213 molds mold compound 311 onto the conductive material having the atomized hexamethyldislazane deposited thereon.

Advantageously, the improvements can be applied in the assembly or "back-end" packaging phase of integrated circuit manufacture. The process improves adhesion and reliability of plastic surface mount devices in overcoming the destructive effects of moisture absorbed by the plastic before reflow soldering occurs, for one example.

The simplicity of the charged atomization apparatus and process also commends them for use not only in the assembly phase but also in wafer fabrication itself. In this way adhesion of photoresist is improved in wafer fabrication and the use of complex, expensive equipment for deposition of the adhesion promoter is obviated.

In general, as soon as adhesion is lost between mold compound and the semiconductor die surface, stress becomes highly concentrated on ball bonds which can lead to destructive failure after a number of temperature cycles or after a single soldering operation.

Advantageously, the atomized dispenser method of FIG. 2 covers both the lead frame and the die surface simultaneously after bonding. Curing of the adhesion promoter in a first alternative approach occurs in the heat (on the order of 180 °C) in the mold press itself during the duration of the molding operation. Advantageously, no separate curing operation or apparatus is called for in this first approach. In a second alternative, a flash cure at a suitable flash cure temperature such as 350 °C is applied for a number of seconds, such as 30 seconds, as the lead frame and die are conveyed on a track past or otherwise held near infrared lamps prior to molding. A third alternative provides an oven cure at 150 to 275 °C for 1.5 hours to 3 hours. It is noted that the skilled worker adjusts temperature, time, separation distances and other physical parameters of the apparatus and process for best results.

In some versions of the finished product of FIG. 3, the HMDS layer or other adhesion promoter layer 321 is vanishingly thin and almost impossible to detect by ordinary optical microscopic examination. (In other versions the layer 321 has substantial visible thickness). The charged atomized approach of FIGS. 1 and 2 deposits a layer, see FIG. 4. The layer is very thin and can be as little as one atom thick, in the latter case called a monolayer. In spite of its thinness, the presence of even an invisible layer 321 can be detected by differentiating between the levels of adhesion versus disadhesion that occur after going through various levels of package stressing.

A device that normally fails due to delamination often shows a certain amount of delamination as soon as it is manufactured and then deteriorates rapidly after it has been subjected to moisture and temperature stresses. If a device is manufactured so that delamination is not initially present, then it also shows a different characteristic under the scanning acoustic microscope inspection technique.

Thus, in FIG. 3 the integrated circuit has the adhesion promoting substance layer 321 of FIG. 4 which may be visually undetectable. The illustration of layer 321 in FIG. 4 is greatly exaggerated in thickness even at the microscopic scale of FIG. 4. The package material 311 has a degree of adhesion to the pins 315.1-.n substantially exceeding the adhesion of the same package material to pins lacking the layer of adhesion promoting substance.

The improvements in adhesion are applicable to numerous other packages such as surface mount IC packages shown in U.S. patents 4,463,217 and 4,495,376. In US-A-4,463,217 a surface mounted IC device package or carrier has notches or castillations in its sides. A first row of leads are positioned in the periphery of the package and a second row of leads are positioned in the notches. In US-A-4,495,376 a carrier has leads extending from the sides and over protuberances into depressions in the bottom of the carrier. Each of the depressions is separated by ribs from the other depressions. Some of the leads are provided with holes disposed adjacent to the exit of leads from the enclosure of the carrier. The leads are tapered along their length toward the protuberances.

In FIG. 5, the difference between stress-strain characteristics of devices with the layer 321 and without it is marked. As stress increases from zero, and in the absence of layer 321 of FIG. 4, a knee 351 is reached at which strain suddenly rises as delamination occurs. By contrast, when even a microscopically undetectable layer 321 is present, a delamination knee 353 occurs at a much higher stress.

The HMDS substance presents a useful alternative to polyimide and some embodiments entirely lack polyimide between the die and the mold compound wherein the die directly adheres by adhesion promoter such as HMDS to the mold compound of the package. Other embodiments provide atomized deposition of polyimide mixed with adhesion promoters in an uncomplicated and inexpensive process improvement.

Merely using hand pliers to mechanically break the package can indicate the presence of the layer 321. A package without the layer 321 provides less adhesion to the die and the lead frame. Thus the mold compound delaminates or separates from the die arid lead frame in the absence of layer 321. With the layer 321 a die of silicon may shatter and and the die and lead frame may exhibit preferential adherence of bits of mold compound not found in the device lacking layer 321.

Some important parameters in plastic package cracking are the die size and ratio of die mount pad to minimum plastic package thickness. Also important are the amount and distribution of moisture absorbed by the plastic prior to sudden temperature elevation. The mismatch between the coefficient of thermal expansion (CTE) of the package and the die and lead frame also affects cracking. As die size increases, the level of stress due to difference in the CTE of silicon, lead frame, and mold compound increases. With thin package cross-sections, this stress exceeds the strength of the plastic thin package cross-sections. Therefore, the ratio of die size or die mount pad, to minimum plastic thickness between die or mount pad surface and external package surface is an important parameter, as is total package thickness.

Some CTE examples in parts-per-million per °C are 2.8 for a silicon die, 6 for an Alloy 42 lead frame, 17 for copper, and 17-26 for molding compound.

Stress due to solder reflow and rework increases with maximum package temperature. The die fabrication and wire bonding processes also provide greater or less resistance to the stress of sudden temperature rises.

The moisture gradient in the region near and at the interface of the plastic and the die or mount pad affects the susceptibility of a package to cracking during reflow soldering. In a normal room environment, many plastic mold compounds absorb moisture at about 0.01 % moisture by weight per day. An average moisture level of about 0.11 to 0.12 % can be enough to cause package cracking on some large die ICs, while other devices may not crack even though saturated to 0.4 or 0.5 % moisture by weight. Where concentration gradients exist due to non-equilibrium conditions, the critical moisture limit for cracking may vary by as much as 0.1 % moisture by weight.

A solder temperature above 220 °C greatly increases the probability of failure, while the temperature ramp-up rate apparently has little effect. If necessary heat shields should be used to prevent overheating of individual devices.

Hexamethyldisilazane (HMDS) has a chemical formula of (CH3)₆Si₂NH. One form of HMDS is 1,1,1,3,3,3 hexamethyldisilazane, see Desk Book of Infrared Spectra, Coblentz Society, 2nd. ed., 1980. Other disiiazanes and other adhesion promoters are also advantageously suitable for this process. Polyimide with adhesion promoters can also be atomized and sprayed according to the process described herein

In one embodiment of the apparatus according to the invention, two nozzles 121 are electrified and placed on opposite sides of the die and lead frame 141,145. In FIG. 1 an overspray portion 129A of the atomized particles of adhesion promoter does reach the die and lead frame from the rear, even though the nozzle 121 is on one side of the die and lead frame. With two nozzles, an even further measure of uniformity of deposition is secured from front and back. In either the single or double nozzle approach the orientation of the die and lead frame 141, 145 can be in a spray-facing position as shown, or rotated edge-on, or even oriented obliquely to the spray. Numerous die and lead frame assemblies are conveyed along a track in assembly line fashion past the atomizer in mass production.

Various devices can be used for atomization. FIG. 1 shows compressed air (or other fluid such as nitrogen or evaporating liquid) aspirating the adhesion promoter through nozzle 121. An alternative device omits the air source 127 and forces the adhesion promoter under pressure through the nozzle 121, effectively atomizing the adhesion promoter. Yet another alternative device uses a vibrator to atomize the adhesion promoter without introducing air.

A few preferred embodiments have been described in detail hereinabove. It is to be understood that the scope of the invention also comprehends embodiments different from those described, yet within the scope of the claims.

Integrated circuits such as illustrated in FIG. 3 can be improved according to the process of FIG. 2 to make improved ASICs (application specific integrated circuits), PAL (programmable array logic), PLAs (programmable logic arrays), decoders, memories, non-software based processors, or other circuitry, or digital computers including microprocessors and microcomputers of any architecture, or combinations thereof. Words of inclusion are to be interpreted as nonexhaustive in considering the scope of the invention.

Internal and external connections can be ohmic, capacitive, direct or indirect, via intervening circuits or otherwise. Implementation is contemplated in discrete components or fully integrated circuits in silicon, gallium arsenide, or other electronic materials families, as well as in optical-based or other technology-based forms and embodiments. It should be understood that various embodiments of the invention can employ or be embodied in hardware, software or microcoded firmware. Process diagrams are also representative of flow diagrams for microcoded and software based embodiments of assembly apparatus.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A process of making a semiconductor component, the component having a semiconductive material (141) and conductive elements (145), comprising the steps of:
providing an adhesion promoting substance to an applicator device (121) operable to atomize the adhesion promoting substance;
establishing a potential difference in the range of approximately 200 to 500 volts between the applicator device (121) and the electronic component (141, 145); and
atomizing the adhesion promoting substance near the electronic component (141, 145) whereby the potential difference attracts the adhesion promoting substance to the electronic component, and providing a mask to direct the adhesion promoting substance both to the front side and to the rear side of the electronic (141, 145) component.

2. The process of claim 1, comprising an additional step of molding a mold compound onto the electronic component (141, 145) having the adhesion promoting substance thereon by encapsulating the electronic component (141, 145) in a mold die and injecting the molding compound into the mold.

3. The process of claim 1 or claim 2, wherein the adhesion promoting substance includes hexamethyldisilazane (HMDS).

4. The process of claim 1 comprising an additional step of providing a mask (151) for directing the adhesion promoting substance to a preferred area of the electronic component (141, 145).

5. The process of claim 2, wherein the step of molding includes curing the adhesion promoting substance during the mold step by the heat of the mold die.

6. Apparatus for making integrated circuits having a semiconductive material (141) and conductive elements (145), the apparatus for use with a molding device (171) and a molding compound, the apparatus comprising:
an applicator device (121) provided with and operable to atomize an adhesion promoting substance which substance is of a type that promotes adhesion between the semiconductive material (141) and conductive elements (145) and the molding compound;
a voltage source (131) connected to establish a potential difference in the range of approximately 200 to 500 volts between the applicator device (121) and the conductive elements (145) of the integrated circuit (141, 145); and
a mask (151) for directing the adhesion promoting substance to a preferred area of the integrated circuit (141, 145).

7. The apparatus of claim 6, wherein the adhesion promoting substance includes hexamethyldisilazane.

## Patentansprüche

1. Verfahren zum Herstellen eines Halbleiterbauelements, das ein halbleitendes Material (141) und leitende Elemente (145) aufweist, enthaltend die Schritte:
Liefern einer haftverstärkenden Substanz zu einer Aufbringungsvorrichtung (121), die so betreibbar ist, daß die haftverstärkende Substanz zerstäubt wird;
Erzeugen einer Potentialdifferenz im Bereich von etwa 200 V bis 500 V zwischen der Aufbringungsvorrichtung (121) und dem elektronischen Bauelement (141, 145); und
Zerstäuben der haftungsverstärkenden Substanz nahe des elektronischen Bauelements (141, 145), wodurch die Potentialdifferenz die haftverstärkende Substanz zu dem elektronischen Bauelement hinzieht, und Anbringen einer Maske zum Lenken der haftverstärkenden Substanz sowohl zur Vorderseite als auch zur Rückseite des elektronischen Bauelements (141, 145).

2. Verfahren nach Anspruch 1, bei welchem zusätzlich eine Gießmasse auf das elektronische Bauelement (141, 145) gegossen wird, auf dem sich die haftverstärkende Substanz befindet, indem das elektronische Bauelement (141, 145) in eine Gießform eingekapselt und die Gießmasse in die Form eingespritzt wird.

3. Verfahren nach Anspruch 1 oder Anspruch 2, bei welchem die haftverstärkende Substanz Hexamethyldisilazan (HMDS) enthält.

4. Verfahren nach Anspruch 1, bei welchem zusätzlich eine Maske (151) vorgesehen wird, um die haftverstärkende Substanz zu einem bevorzugten Bereich des elektronischen Bauelements (141, 145) zu lenken.

5. Verfahren nach Anspruch 2, bei welchem der Gießschritt das Aushärten der haftverstärkenden Substanz während des Gießschritts durch die Wärme der Gießform enthält.

6. Vorrichtung zum Herstellen integrierter Schaltungen mit einem halbleitenden Material (141) und leitenden Elementen (145) für die Verwendung mit einer Gießvorrichtung (171) und einer Gießmasse, mit:
einer Aufbringungsvorrichtung (121), die mit einer haftverstärkenden Substanz versorgt wird und diese zerstäuben kann, wobei die haftverstärkende Substanz eine Substanz eines Typs ist, der die Haftung zwischen dem halbleitenden Material (141) und den leitenden Elementen (145) und der Gießmasse verstärkt;
einer Spannungsquelle (131), die so angeschlossen ist, daß sie zwischen der Aufbringungsvorrichtung (121) und den leitenden Elementen (145) der integrierten Schaltung (141, 145) eine Potentialdifferenz im Bereich von etwa 200 V bis 500 V erzeugt; und
einer Maske (151) zum Lenken der haftverstärkenden Substanz auf einen bevorzugten Bereich der integrierten Schaltung (141, 145).

7. Vorrichtung nach Anspruch 6, bei welcher die haftverstärkende Substanz Hexamethyldisilazan enthält.

## Revendications

1. Un procédé de fabrication d'un composant semi-conducteurs le composant ayant un matériau semi-conducteur (141) et des éléments conducteurs (145), comprenant les phases consistant à :
fournir une substance provoquant une adhésion à un dispositif applicateur (121) actionnable pour atomiser la substance provoquant l'adhésion ;
établir une différence de potentiel dans la gamme d'approximativement 200 à 500 volts entre le dispositif applicateur (121) et le composant électronique (141, 145) ; et
atomiser la substance provoquant l'adhésion à proximité du composant électronique (141, 145) grâce à quoi la différence de potentiel attire la substance provoquant l'adhésion vers le composant électronique, et disposer un masque pour diriger la substance provoquant l'adhésion à la fois vers la face avant et vers la face arrière du composant électronique (141, 145).

2. Le procédé de la revendication 1, comprenant une phase supplémentaire consistant à mouler une composition de moulage sur le composant électronique (141, 145) comportant sur lui la substance provoquant l'adhésion en encapsulant le composant électronique (141, 145) dans une matrice de moule et en injectant la composition de moulage dans le moule.

3. Le procédé de la revendication 1 ou de la revendication 2, dans lequel la substance provoquant l'adhésion comporte de l'hexaméthyldisilazane (HMDS).

4. Le procédé de la revendication 1 comprenant une phase supplémentaire consistant à disposer un masque (151) pour diriger la substance provoquant l'adhésion vers une zone de surface préférée du composant électronique (141, 145).

5. Le procédé de la revendication 2, dans lequel la phase de moulage inclut le durcissement de la substance provoquant l'adhésion pendant la phase de moulage par le chauffage de la matrice de moule.

6. Appareil de fabrication de circuit intégrés comportant un matériau semi-conducteur (141) et des éléments conducteurs (145), l'appareil étant utilisé avec un dispositif de moulage (171) et une composition de moulage, l'appareil comprenant :
un dispositif applicateur (121) muni de et adapté pour atomiser une substance provoquant l'adhésion, laquelle substance est d'un type qui provoque une adhésion entre le matériau semi-conducteur (141) et des éléments conducteurs (145) et la composition de moulage ;
une source de tension (131) reliée pour établir une différence de potentiel dans la gamme d'approximativement 200 à 500 volts entre le dispositif applicateur (121) et les éléments conducteurs (145) du circuit intégré (141, 145) ; et
un masque (151) pour diriger la substance provoquant l'adhésion vers une zone de surface préférée du circuit intégré (141, 145).

7. L'appareil de la revendication 6, dans lequel la substance provoquant l'adhésion comporte de l'hexaméthyldisilazane.
